Europäisches Patentamt

European Patent Office

Office européen des brevets

(19)

(11) Publication number: **0 247 308**
**A2**

(12) # EUROPEAN PATENT APPLICATION

(21) Application number: **87104072.1**

(51) Int. Cl.⁴: **G01R 31/28**

(22) Date of filing: **20.03.87**

(30) Priority: **27.05.86 IL 78943**

(43) Date of publication of application:
**02.12.87 Bulletin 87/49**

(84) Designated Contracting States:
**DE FR GB**

(71) Applicant: **International Business Machines
Corporation
Old Orchard Road
Armonk, N.Y. 10504(US)**

(72) Inventor: **Bruck, Jehoshua
81-F, Escondido Village
Stanford California 94305(US)**
Inventor: **Ramm, Dov
3 HaEmek Street
Givat Amos Haifa 33073(IL)**

(74) Representative: **Rudack, Günter O., Dipl.-Ing.
IBM Corporation Säumerstrasse 4
CH-8803 Rüschlikon(CH)**

(54) **Method and apparatus for automated optical inspection of printed circuits.**

(57) The surface of a printed circuit is optically scanned and the data acquired, after some preprocessing, compared to reference data representing a fault-free printed circuit. The preprocessing involves a reduction of the conductivity of the lines in the circuit to connectivity of particular features of the lines. The comparison is carried out by establishing a correspondence between global labels in check points of a certain type, and pre-computed reference global labels in corresponding points, and the global labels of other check points are compared with corresponding ones of the reference, with any miscorrespondence indicating a defect of the 'open circuit' type, while any merge event between different global labels indicates a defect of the 'short circuit' type.

The apparatus consists of an optical front end (1) having a data acquisition scanner and pre-processor (6); a signal distributer (2) comprising a first look-up table (8), a transformation unit (9) and a second look-up table (10); a reference comparison subsystem (4) comprising a reference disk (11), a decompressor (12), a comparator (13) and a microprocessor (15); and a general conductivity analysis subsystem (3) comprising a second level signal pro-
cessor (17) and a host computer (14), the said subsystems being connected to a main host computer (5).

FIG.1

## METHOD AND APPARATUS FOR AUTOMATED OPTICAL INSPECTION OF PRINTED CIRCUITS

This invention relates to a method and an apparatus for the optical inspection of printed circuits. A general problem with printed circuits resides in the operability of the entirety of their components, in particular in case the end product is a multi-layer circuit board where many layers of printed circuits are interconnected to form one operational unit. A failure in one layer, in one component or a connecting line can be fatal for the entire circuit board and thus cause a significant loss in yield, labour and resources.

Existing methods of optical inspection either use a huge and hardly manageable amount of reference information, as is true for reference comparison methods, or have a rather high rate of escapes and false alarms, as with design rule methods.

A high rate of false alarms prohibits fully automated decision making and involves costly human intervention in order to define manually, whether a suspected region contains a fatal fault. Escapes are intolerable at all, as they lead to rejection of an expensive assembled board.

The desired properties of a method for automated optical inspection involve the following:

-Zero escape and false alarm rates. Only fatal faults are detected.

-No manual intervention in the detection process.

-Small reference data volume.

-Processing of incoming raster scan data at data acquisition speed.

-On-the-fly fault detection to enable snap-shot of fault vicinities.

These requirements can not be simultaneously met by existing approaches as they involve various error definitions which do not necessarily correspond to a fatal fault, i.e. a fault which will cause a circuit malfunction.

The method proposed by the present invention meets all of these requirements by combining the full-bit reference comparison of large homogeneous areas with the conductivity analysis of line patterns.

If a printed circuit contains only connecting lines, as in a signal layer of a multilayered printed circuit board, the proposed method reduces to a generalized conductivity analysis of a printed circuit bit image, which is conceptually equivalent to a real electrical connection/isolation test, and as such reliably ascertains correct connections between line terminations. A combination of the generalized conductivity analysis with the reference comparison for only large areas provides high reliability of inspection, while keeping the reference volume small.

There exist two basic approaches for automated optical inspection:

1. The "reference comparison approach", in accordance with which the tested image is compared with the reference image either in all available points, or in certain areas, or even along vectors through conductive trace centers.

The advantages of this approach are its algorithmic simplicity and the absence of escapes. The disadvantages are a high rate overkills and the huge reference data volume required.

Overkills, i.e. false alarms, are caused by small distortions on a conductor trace, which are interpreted as miscorrespondences between the data and the reference, although they do necessarily cause a circuit malfunction. In order to filter out false alarms, each discrepancy between data and reference and reference should be analyzed further by some intelligent processor.

An addition of a "don't care" region around conductor edges reduces this problem from completely intractable to a hardly manageable one, since the false alarm rate remains still large. The situation may be especially severe, as technology grows finer and a conductor trace width becomes comparable to distortion size.

In the worst case, the reference comparison method has to keep the full reference as well as the care/don't care information, which may amount to 1000 Mbytes per layer. A compression may reduce the reference volume down to 10 - 20 Mbytes, the compression ratio, however, decreases with increasing density of the reference image, thus leaving the reference volume still huge for dense line patterns. Besides this, a fast on-the-fly decompression becomes a problem.

2. The "design rule approach", in accordance with which the fault detection is done by checking whether an inspected image corresponds to local design rules, such as typical local feature size, form, shape, etc.

The advantages of the design rule approach are relative simplicity and small reference data volume. However, this approach suffers principally from both, escapes and false alarms. For example, it cannot detect a completely missing feature, as well

etonized reference image, such as terminal points. An edge between two reference vertices is a direct connection between them with a conductive trace which does not pass through other vertices.

The input data, prior to its comparison with the reference, is also organized as a graph ('self-related' or SR-graph) in accordance with the same rules, namely, its vertices are special points of a skeletonized image, its edges directly connect vertices.

As a first step of a comparison, the matching is done between the vertices from the input data and the corresponding vertices in the reference using metric criteria - the location coordinates and a tolerable distortion, and possibly topological - as a vertex degree.

After the matching, an SR-graph representation of the input data is rebuilt with the purpose of creating a 'reference-related' or RR-graph representation of data, which had to be further compared with the reference graph. Vertices of an RR-graph are only so called T-vertices, the 'true' vertices of a data SR-graph, which were matched to the reference. Vertices for which their reference match doe not exist, are referred to as 'pseudovertices' (P-vertices).

An SR-graph may be decomposed into a union of separate connected components, each one of which is as though colored with its color, different colors being separated by T-vertices. Among these components there are edge-like 'regular' components, with less than three edges, incident to T-vertices, and faulty 'irregular' components, with more than two edges, incident to T-vertices. An edge between two T-vertices of an RR-graph exists if, and only if, the vertices are connected to a regular component which may contain P-vertices, but no other T-vertices).

The above may be reformulated in the following terms. All vertices are withdrawn from the skeletonized data, thus facilitating the decomposition of the data skeleton into an SR-graph. The building of an RR-graph is equivalent to bringing back into an SR-graph those vertices, which did not exist in the reference graph. These pseudovertices are now considered as parts of lines, connecting 'true' (matched to the reference) vertices.

The RR-graph representation is computed online, i.e. a while after a data special point matching matching the RR-graph is updated and becomes known down to a current scanning line.

In order to detect a fault, the only thing to be done is a check whether the reference and the input data graphs are equivalent, while knowing the correspondence of the vertices. Faults are flagged, if they cause either location or 'local' connectivity violations, namely in the following cases:

1. An incorrect location (or missed feature):
There is a reference vertex, which was not matched to any data vertex.

2. An 'open circuit':
There is an edge in the reference graph which does not exist in the input data RR-graph.

3. A 'short circuit':
-There is an edge in the input data RR-graph which does not exist in the reference graph.
-There is an irregular component in the data graph, which shorts together more than two reference vertices.

For a signal layer, the extended algorithm reduces to the basic algorithm, suited, however, for an on-line connectivity analysis.

A straightforward modification of the 'generalized conductivity analysis' approach relates to the case where there are several different line widths on the same layer. In this case weights may be given to reference graph edges in order to designate a specific line width. For the data graph it is assumed that the corresponding weights may be computed from optically acquired data, while each change of computed weight represents an SR-graph vertex. As before, a fault-free pattern has to have an equivalent to the reference RR-graph, while the equivalence includes some relation between the edge weights of RR-graph and the reference graph.

In accordance with the present invention, the 'Combined System' approach, the reference comparision and the 'generalized conductivity analysis' approach are joined together. The combined system consists of the following:

1. A data acquisition block,
2. The 'generalized conductivity analysis' subsystem,
3. A Reference Comparison subsystem,
4. A Data distributor, which separates data for both subsystems.

In the Data Distributor, a 'supernarrowing' transformation is performed on the incoming binary data flow with the purpose of producing on-the-fly two separate binary signals for each pixel of an inspected circuit image. These two signal flows are fed each to separate inspection hardware. The first flow with only wide area information is fed into a full reference comparison scheme, which compares this flow with a specially organized reference. This reference conveys information on wide areas as it follows from the design data and has a small volume, as greater compression is possible. The second data flow with only line pattern information is fed to the generalized conductivity analysis - scheme, which performs a conductivity analysis and compares the result with the conductivity reference.

The basic structure of the 'generalized conductivity analysis' implementation contains two levels of processing. The first level consists of a special purpose hardware and processes all the input data at the data acquisition rate with the purpose of forming a compressed description of the conductivity information. This compressed information is processed further and is compared against the reference description by a second level processor, which handles a high level description of the input data.

The generalized conductivity analysis is extended for analyzing multiconnected line patterns, printing snap-shots of detected faults and performing some averaging operations over the data.

The main function of the first level is to extract the compressed high-level information from the input stream. It is preferable to perform that extraction after skeletonizing a preprocessed image. The idea is to disconnect entities in their special points like 3-joints, 4-joints and, optionally, in some other points, like label 'merges' or 'starts' of a new label, and to apply a local component labeling to disconnect skeletal segments, hereinafter referred to as 'ropes'.

There are two main mechanisms in the first level:

-Transforming the input image into a 'rope' image by skeletonizing and deleting special skeleton points. Types and locations of deleted points are passed to the second level.

-Component labeling of the rope (skeletal segment) image. Labels and locations of rope terminals are passed to the second level. If points, where merges of two different labels occur, are also deleted, then in addition a single rope is labeled by a single label.

Additional problems appear when an ideal board (reference) contains 4-joints, which are usually transformed after real data skeletonizing into clusters of 3-joints. To simplify an algorithm for the second level processing, it was proposed to withdraw from the skeleton all 3-joints (and possibly other special points) with their several nearest neighbors by special mark propagation and to perform an additional auxiliary component labeling of withdrawn parts (preferred to as 'knots') in order to identify them as vertices.

To summarize, the main functions of the first level are:

-Broadening/narrowing - to reduce conductivity to connectivity.

-Skeletonizing - to get a simple representation of the input image.

-Deletion of special points - to get a rope (skeletal segment) image.

-Component labeling - to identify two terminals of each rope.

-Possible marking of deleted points - to get a knot image.

-Possible auxiliary component labeling of knots - to identify vertices.

-Passing the information on special points to the second level.

The first level should have the following additional characteristics:

-Possible presence of either a number of identical channels for parallel operations (e.g. broadening for near short circuit detection and narrowing for near open circuit detection or a special - scheme ('distance transformer') for the computation of edge weights.

-Possible presence of an additional 'arithmetic' channel for average line width detection or another averaging operation.

-Possible presence of the 'snap-shot' channel in order to delay original data until a command is issued for on-the-fly fault documentation.

-Possible presence of mask gate at the input of the 'generalized conductivity analysis' subsystem for the elimination of border miscorrespondence.

The second level processor completes the analysis of the information received from the first level. The matching may be performed either on the second, or on the first level. For each matched pair of vertices, the second level checks whether the data T-vertex is connected with the same T-vertices as the reference vertex. This check relates only to that part of an inspected board which was already scanned. Since in the data graph a connection may pass through P-vertices, the second-level processor keeps track of label equivalence of all labels arriving at each P-vertex. The equivalence tracking is maintained through a union and find mechanism known from "Data Structures and Algorithms" by A.V. Aho, J.E. Hopcroft and J.D. Ullman, Addison Wesley, 1983.

Ropes with not yet encountered second edge obviously intersect a current scanning line. Some of the ropes may be interconnected through P-vertices. Using a description of these connections in the union and find mechanism, the second level for every T-vertex keeps track of the amount of active disconnected entities which are initiated on this vertex. This amount, an 'activity' number of a T-vertex, has to be not less than the reference vertex activity number. The second level processor discovers violations of this condition and interprets them as 'open' or 'short' events, depending on the type of P-vertex, on which a violation happens. An activity number is defined as well for each data entity and equals an expected number of entity terminal points, which have not yet been encountered in a scanning process. When an entity activity number decreases to zero, that entity is finished and should not be followed any more.

The second level keeps track of a number of T-vertices connected to each data entity, flagging a 'short' if this number is greater than 2, that is, an entity is an irregular component. Besides this the second level discovers reference vertices, which remain unmatched to the data and flags them as vertex location faults.

The preferred hardware embodiment is based on parallel processing with pipelined processing elements. A processing element (PE) serves as an elementary building block, which realizes at a moment n values of logic functions Fi of 9 input bits, gathered from a $3 \times 3$ neighborhood of a current (central) pixel C, and possibly two additional control bits C1, C2. For the purpose of this invention, a PE is recursive, so that an i-th PE output Oi depends on the whole history of the input IN, rather than on a $3 \times 3$ neighborhood of the input image:

$$Oi(n) = Fi( IN(n-1), IN(n-2), IN(n-3),$$
$$IN(n-1-l), IN(n-2-l), O1(n-1),$$
$$O1(n+1-l), O1(n-l), O1(n-1-l), C1, C2)$$

$$= Fi ( Br, B, BL,$$
R, C, L, (l is a line size).
TR, T, TL, C1, C2).

The letters T, B, L, and R are used to designate the positions in a $3 \times 3$ neighborhood and respectively stand for 'top', 'bottom', 'left' and 'right'. Accordingly, 'TL' means 'top left', etc.

However, if the first output O1 is defined as O1 = C = IN(n-l-2), then a PE works actually only on an input $3 \times 3$ neighborhood without recursion.

Each output at the moment n is associated with the same pixel, as C = IN(n-2-l). Usual TV scanning order is assumed.

A PE may be thought of as consisting of input and output pipelines. The output pipeline is fed from the O1 output. To provide simultaneous access to the 9 bits of a pixel neighborhood, the entries C, R, BL, B, BR are tapped from the input pipeline, and entries L, TR, T, TL are tapped from the output pipeline. The above 9 bits together with control signals constitute an address for a look-up table with values of logic functions.

A PE receives and processes an image at data acquisition rate, as a stream of input data as it is produced by an image scanning device. The output of a PE is also a stream of usually up to 4 bit wide data, at the same rate as the input data; so processing elements may be connected serially or in parallel.

All usual operations of the binary image processing may be readily implemented with the descibed structure of processing elements. In the the following description, certain standard processing elements are oftenreferred to as: DELAY, which operates as a simple delay, NAROW4, NAROW8, BROAD4, BROAD8, which operate as a narrowing or broadening in accordance with the 4-or 8-connectivity definition.

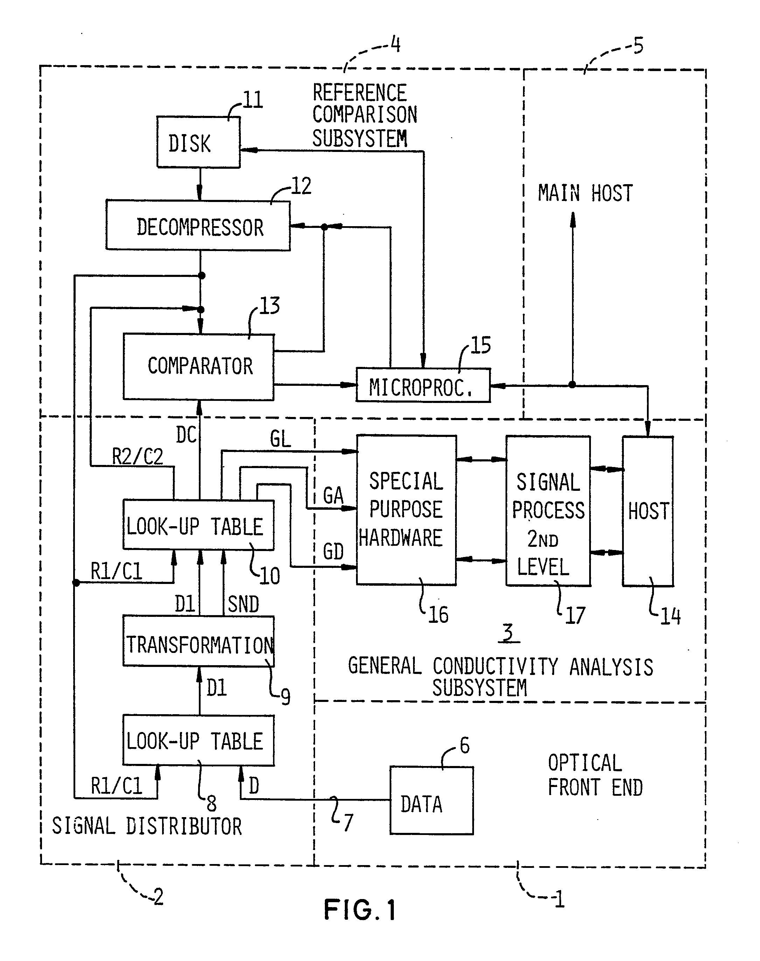

A block diagram of the proposed Combined System is shown in Fig. 1. The system consists of an optical front end unit 1, a signal distributor 2, a generalized conductivity analysis subsystem 3, and a reference comparison subsystem 4. Both subsystems are interconnected and have a connection to a main host computer 5.

The optical front end 1 comprises a data gathering unit, such as an optical scanner 6 which may be followed by a suitable gray level preprocessing system not shown. Its output on a line 7 is a binary data stream arranged in the order of scanning.

The signal distributer 2 comprises a first look-up table 8 (LUT1) connected to a transformation unit 9 the outputs of which are in turn connected to a second look-up table 10 (LUT2). Both look-up tables 8 and 10 may be implemented as read-only memories (ROM). The operation of the signal distributer involves the choosing, by LUT1 8 of an input signal either from optical scanner 6 or from a reference source in reference comparision subsystem (RCS) 4, that is either D1 = D, or D1 = R1, or D1 = C1. In the latter two cases, the reference signal may be fed into subsystem 3 for the computation of an automatic reference signal. The LUT1 is preset by presetting its control inputs (not shown).

Transformation unit 9 performs the supernarrowing operation. It consists of two parallel pipelines of processing elements (PE), one being a cascade of narrowing PE's with NAROW8 and NAROW4 alternating, the other serves to delay the signal D1. Each narrowing element may be switched by a control bit to operate as a pure delay circuit. Thus, by setting control bits, an appropriate depth of supernarrowing is achieved.

Look-up table 10 (LUT2) is the main part of the signal distributor. It has four signal inputs: R1 (reference), C1 (care), D1 (data, SND (supernarrowed data) and several control inputs for choosing the program (not shown). LUT2 10 has six output signals: R2, C2 (modified reference and care), DC (data for the comparison system), GL and GA (data for logical and arithmetic channels of the generalized conductivity analysis subsystem (GCAS) 3), and GD (data for the snapshot channel of the GCAS 3). An additional output signal GC may be added for controlling the arithmetic channel (not shown).

In the reference comparison subsystem 4 (RCS), a compressed information is read from a disk 11 and decompressed on-the-fly by a decompressor 12. The output signal of the decompressor 12 usually contains a two-bit data stream, viz. the reference and the care/don't care zone: R1/C1. The binary data DC on the input of RCS 4 is compared by comparator 13 with the (modified) reference R2, taking into account the (modified) care information C2.

The RCS 4 is supposed to include on-the-fly facilities for the dynamic alignment of the reference R2 against the incoming data DC. For this purpose a signal from comparator 13 is fed back to decompressor 12. An alternative to this technique is the use of dynamic offset information, computed in the GCAS 3. For this purpose, the host computer 14 of the GCAS 3 is connected through a microprocessor 15 of the RCS 4 to decompressor 12.

The microprocessor 15 analyses the fault area in order to filter out false alarms. It also controls the disk unit 11 and is connected to the main host 5 for initial loading and reporting.

The generalized conductivity analysis subsystem 3 checks the conductivity of line patterns and compares it with a reference list. It comprises a special purpose hardware unit 16 for the first level processing, and signal processors 17 for the second level processing, all under control of host processor 14.

As soon as control bits are set, e.g. by loading from host processor 14, one of several possible programs is chosen and a number of narrowing operations in a transformation unit 9 is fixed. During the processing, both the reference comparison subsystem 4 and the generalized conductivity analysis subsystem 3 work together synchronously. Each system independently processes corresponding signals which corresponding signals, which may be defined, for example, may be defined, for example, as DC = SND, GL = GA = D-SND.

The flexibility of the signal distribution in the Combined System makes it possible to combine signals in a number of other ways, e.g. in a care zone, the input DC to the reference comparison subsystem 4 may be defined equal to the original data D, reference and care may be redefined etc. As obvious examples, one of the subsystems 8, 10 may be forced by a corresponding signal definition to work idle. However, by special definition of LUT2, the system acquires some new properties, providing an ability of inspection of some complex patterns, which cannot be inspected by either the RCS 4 or the GCAS 3, if they are used as stand alone tools. Upon the completion of an inspection run, error logs of both subsystems may be combined by the main frame.

The following modifications are possible:

1. The reference file of the RCS 4 may contain more than 1 bit of care/don't care information and, accordingly, decompressor 12 have more than two bits on its output, providing the information on additional areas, e.g. areas with inscriptions, where the GCAS 3 has to work in a special way or has to completely discard them. The signals DC, GL, GA are chosen in accordance with all bits of the decompressor output.

2. Particularly, the reference file of the RCS 4 may contain a special care bit to indicate 'check points' (small areas) for the GCAS 3, in this case the thinning operation in the GCAS 3 may be omitted.

3. Additional control signals for the GCAS 3 may be defined which, when fed into the GCAS, change control of the LUT's in the GCAS internal processing elements and, thus, on-the-fly modify the processing by the GCAS 3.

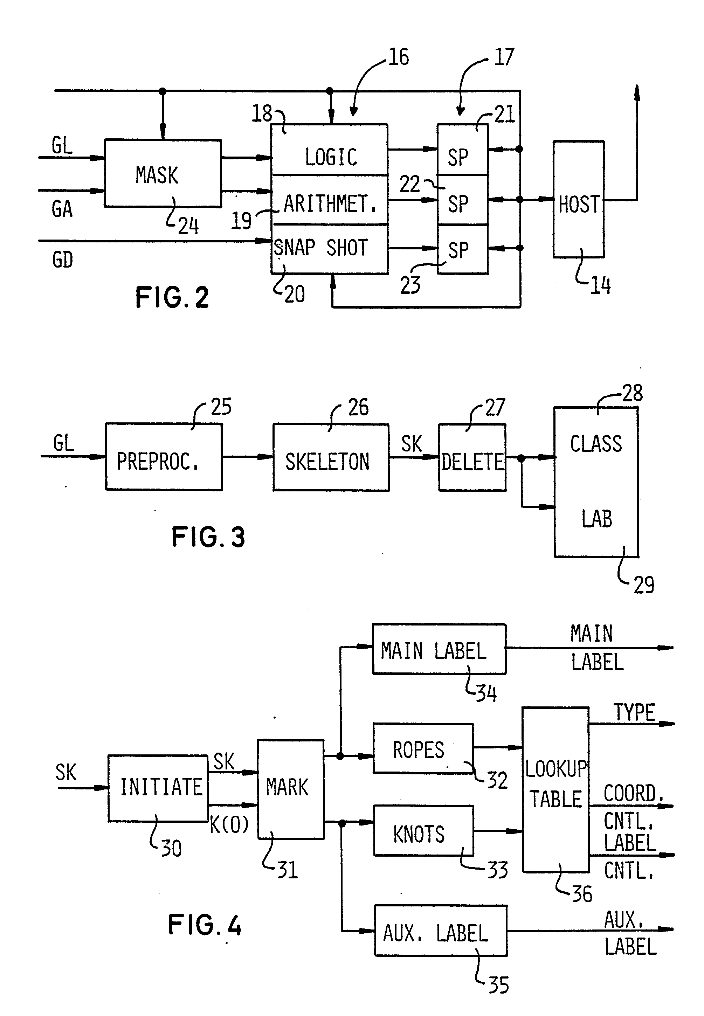

The special purpose hardware 16 of the GCAS 3 is shown in Fig. 2. It executes all algorithms by parallel processing, maintaining the processing rate equal to the data acquisition rate at the optical front end 1. It contains at least one logical channel 18 (possibly three identical channels) and, optionally, an arithmetic channel 19, and a snap-shot channel 20.

The first-level hardware, i.e. channels 18, 19, 20, is interfaced to second-level signal processors 17, each channel having at least one associated processor 21, 22, 23. The second-level signal processors 21 through 23 are interfaced to host 14 of the GCAS 3.

A mask gate 24 is recommended in the case the X-dimension of an inspected board is greater than an image line, and an inspection has to be performed in several overlapping strips. Mask gate 24 serves for the right and left adjustment of the incoming data in accordance with a current reference strip, with which a board strip has to be compared. Signals GL and GA from the signal distributor 2 are set to 0 on several pixels at the beginning and at the end of each row according to offsets transferred from the host 14 to the mask gate 24. The mask gate may actually be implemented in the signal distributor 2, using its LUT2 10.

The information from every channel (18, 19, 20), after completion of processing, is transferred to its second level processor 21, 22, 23. The second level processors 21, 22, 23 are interfaced with each other and with the host 14. The host has in addition lines for the following:

-preloading processing programs (parameters) to each logical channel 18 and the arithmetic channels 19 (the preloading line is shown only for the upper channel),

-preloading the data distributor 2,

-loading the mask gate 24 with offsets during the inspection run,

-issuing signals to the snap-shot channel 20 on coordinates of detected faults.

The host 14 of the GCAS 3 is interfaced to the main host computer 5 in order to load the GCAS 3 reference from host 5 to the GCAS 3 or vice versa and to report the error log to host 5 during an inspection run.

The connection to the microprocessor 15 enables dynamic offset transfer to the reference comparison subsystem RCS 4.

The basic block diagram of the logical channel 18 of special purpose hardware 16 of the GCAS 3 is shown in Fig. 3. Channel 18 comprises a preprocessing unit 25 which receives the GL input signal and which is connected to a skeletonizing unit 26. The latter connects to a deletion circuit 27 the output of which is connected to a special point classifier 28 and to a labeling circuit 29.

The preferred preprocessing for the simplified implementation is narrowing or broadening of all conductive entities. It is possible to use some more advanced preprocessing algorithms, such as the so called "distance transform", which will be explained below.

A choice between narrowing and broadening as well as a parameter of the preprocessing (a 'depth' of narrowing or broadening) are preset prior to performing an inspection run through control bits of processing elements.

The preprocessed data are skeletonized, so that a conductive trace reduces to a line with a width of one pixel. All special points of the skeleton SK are detected and some of them, as 3-joints, 4-joints (and possibly others, as 'merge' points) are deleted from the skeleton. At the output of the deletion block, only disconnected pieces of the skeleton are present. These pieces will be referred to hereinafter as 'ropes'. The component labeling is performed on these 'ropes' (signal RP), so that the second level may define whether or not some terminal or other check points belong to the same rope. Information on deleted points, however, is kept for the final special point classification in classifier 28.

The classification may be done by using the immediate neighborhood of a special point. The information on special points is transferred to the second level processor and includes special point type, coordinate and label(s). The second-level processor receives all information on special points, including 'merge' events, when two different labels are merged. This information is sufficient for an on-line analysis of a data connectivity graph and for its comparison with the reference connectivity graph, as explained above. All messages to the second level are prepared in a message formatter and may be loaded to a FIFO (first-in/first-out buffer) before shipping to the second level.

A modified version of the GCAS 3 takes care of a problem of special point clusters, which are caused by a presence of 4-joints in the reference. A reference 4-joint is usually transformed to a number of closely clustered 3-joints, which have to be identified as one 4-joint. The presence of clusters adds a considerable load and complexity to the second level. The problem can be solved by appropriate modification of the hardware. The block diagram of a possible implementation for the modified version of the GCAS 3 is shown in Fig. 4.

Instead of to the deletion circuit 27 of Fig. 3, the output of the skeletonizing unit 26 may be connected to an initiation circuit 30 the outputs of which lead to a marking unit 31. The two output of marking unit 31 are connected to a pair of detection circuits 32, 33, respectively provided for detecting ropes and knots, as well as to two labeling units 34, 35, respectively associated with main and auxiliary labels. The detection circuits 32, 33 are both connected to a look-up table 36.

Special points of certain type are marked "1" (all other points are "0"), producing an initial marking signal K(0). Then all skeleton points, which have already marked neighbors, are also marked. After several stages of the marking process, all marked points, except those marked in the last stage, are deleted from the skeleton. At the completion of the marking/deletion procedure, two binary data streams are present: one data stream (RP) contains disconnected skeleton segments (ropes), the other data stream contains small parts of the skeleton around its special points. These skeleton parts are hereinafter referred to as special point 'knots'. Knots and ropes have common points which are 1-joints of both.

Labeling is performed simultaneously in separate blocks: main labeling of ropes (RP) and, in addition, auxiliary labeling of knots. Possible merges of auxiliary labels as well as values of auxiliary label in terminal points of ropes are transferred to the second level. Auxiliary labeling provides convenient means to find all ropes which are interconnected through a knot.

The classification is done in two steps: The first step is performed in the special point marker in order to identify points to be marked, the second and final step is done after marking and deletion.

The signals for ropes and knots are fed to separate detectors which define the type of the special points, both types being combined in the final lock-up table LUT 36 for final classification. Both detectors are implemented as simple processing elements with 4 bit output, whose templates are chosen in accordance with special points neighborhoods. Look-up table 36 has three additional output control bits as control signals for the transfer of a main label, an auxiliary label and a coordinate.

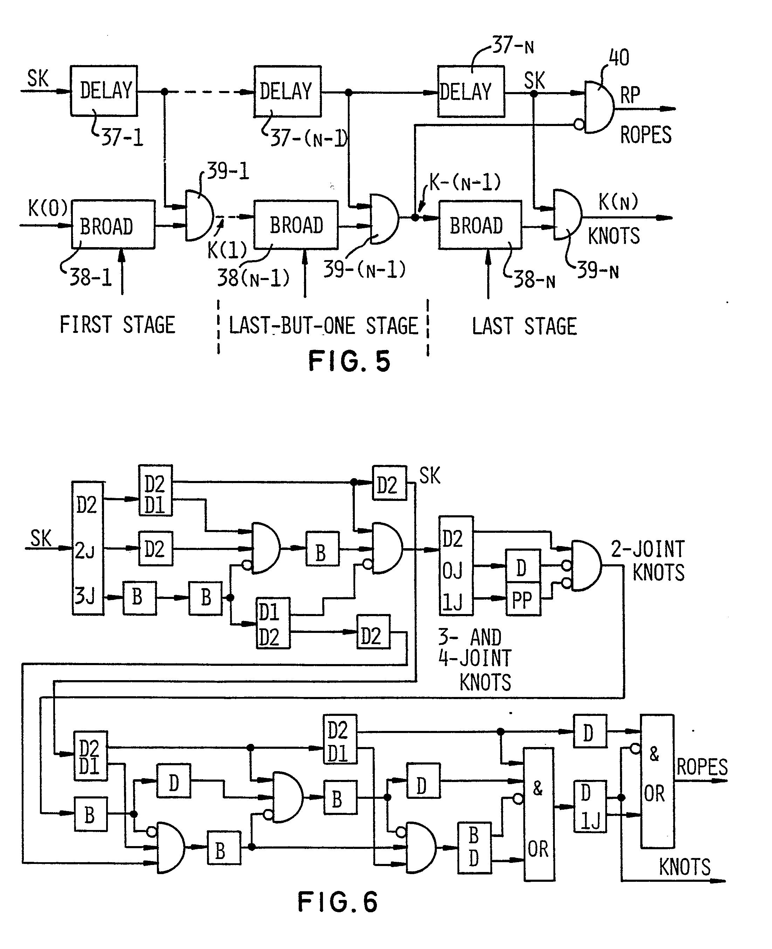

A schematic block diagram of a possible implementation of the marking unit 31 of Fig. 4 is shown in Fig. 5. All stages of the unit comprise a delay circuit 37-1...37-n, a broadening circuit 38-1...38-n, and an AND gate 39-1...39-n. The last stage has an additional AND gate 40. Its K(n-1) input is inverted.

The last stage of the marking unit serves for forming two signals respectively relating to ropes and knots, and, therefore, is not controlled by a control signal. Thus, the minimum number of marking stages is one which means that immediate neighbors of initially marked points are always included to knots.

Logical AND functions between marking stages may be implemented in the look-up tables of marker processing elements.

The marking may be carried out differently for special points of various type and in such a way that knots, which belong to different types of special points, will never intersect. A hardware implementation of a marker which avoids intersection of 2-and 3-joint knots, and which includes small voids in a knot, is shown in Fig. 6. Here D = D1 and D2 designate a delay of one or two rows, respectively. B stands for a broadening circuit 38 BROAD4 (Fig. 5), 0J, and 1J are processing elements, which detect 0-, and 1-joints, respectively, 2J detects 'merge' and 'start' events, 3J detects 3- and 4-joints, PP detects horizontal and and vertical pairs of points. Separate logic functions are indicated in the diagram; they are actually implemented in read-only memories.

In the first initialization stage, 2-joints and 3-joints are separately detected first, producing 2-and 3-knot signals. Secondly, two points of 2-knots adjacent to a 3-knot are deleted, and a 2-knot is broadened on its nearest neighbors in such a way that this is always one zero pixel between 2-and 3-knots. Thirdly, after this initial broadening, isolated points and isolated pairs of points on a 2-joint knot are deleted. In following stages, 2-and 3-knots are broadened in turn; there is, however, always one unmarked pixel in between. In the last stage, a union of both kinds of knots is produced, resulting in a knot signal. In parallel, all skeleton points, which do not belong to knots and 1-joints of knots constitute a rope signal.

For ease of clustering and classifiction, the 4-connectivity is employed for thinning, as preferred over the 8-connectivity. The thinning algorithm, implemented by processing elements, was first proposed by J. Mandeville in the IBM J. Res. Dev.,

Vol. 29, no.1, January 1985, for 8-connectivity definition, but may be easily adapted for 4-connectivity as well. The diadvantages of this algorithm are increased hardware complexity and sensitivity to small irregularities.

The algorithm developed for the purposes of this invention requires less hardware (three processing elements versus four in the Mandeville algorithm) and is less sensitive to small conductor irregularities. However, it treats one and two pixel wide lines as skelton lines. To obtain a skeleton with a one-pixel width, as a final step a single stage of Mandeville's algorithm, tailored to 4-connectivity thinning and accompanied with trimming, is used, which requires 4 additional processing elements.

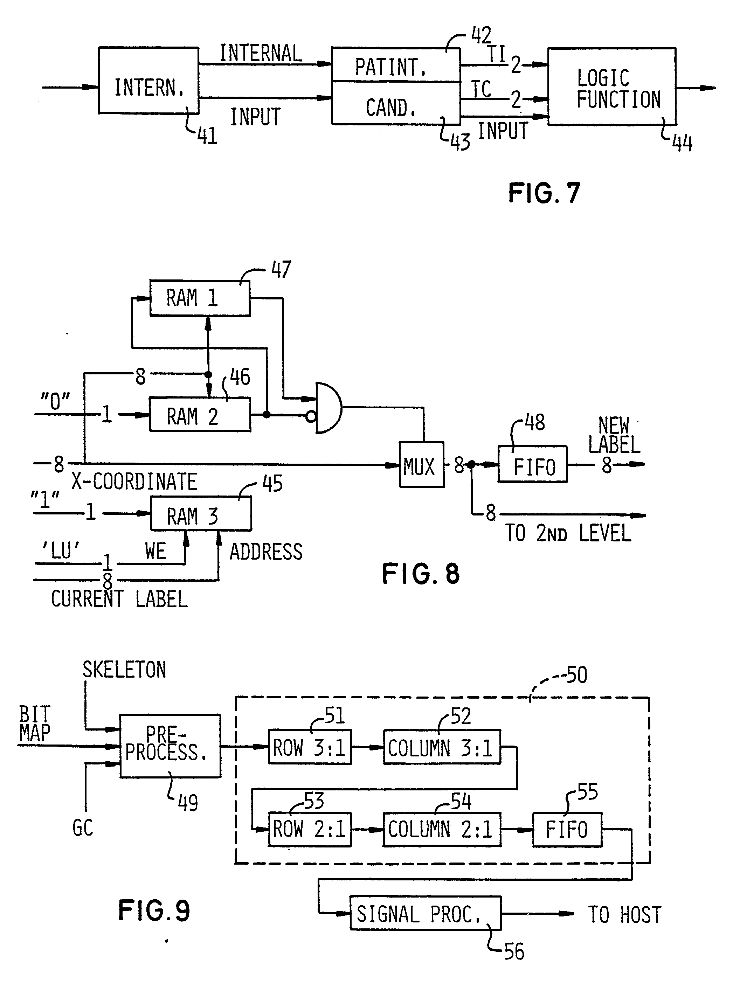

The description of the new algorithm is as follows. The pixel is defined as 'internal' if it and all four of its neighbors equal 1, in agreement with the 4-connectivity definition, and there are no two diagonally opposite neighbors which equal 0 at the same time. Internal pixels should not be erased by a thinning operation. The corresponding processing element 41 is designated 'INTERN' in Fig. 7. It also serves to appropriately delay the input.

A boundary pixel has to be erased only if it satisfies certain conditions, in order to leave a sufficiently large amount of ones behind this pixel. The following patterns demonstrate situations when the boundary pixel in the center of a $3\times3$ window should be deleted. The letter 'i' stands for internal pixel, in accordance with the above-given definition. There are certain pixels outside of the window which have to be '1' because they are adjacent to the internal one. These pixels with the implied value of '1' are designated '*'.

Situations for deletion of boundary pixels:

Type 1. All possible rotations of the following patterns:

```
0 0 x     0 0 0     x 0 x     x 0 0
1 1 0     1 1 1     0 1 0     0 1 1
1 i 1     1 i 1     1 i 1     1 i 1
 * *        *       * * *      * *
```

Type 2. All possible rotations of the patterns:

```
x 0 0
0 1 1 a   a + b = 0
0 1 i *
b *
```

Type 3. All possible rotations of the patterns:

```
x 0 1     0 0 1     0 1 1
0 1 i *   1 1 i *   0 1 i *
1 i i *   1 i i *   1 i i *
  * *       * *       * *
```

To detect the appearance of any one of these patterns, a comparison is made of input signal patterns and of internal points patterns. The above 3×3 patterns of input signal, where 'i' stands for an internal pixel, are used for sifting out candidates for deletion. The processing element 42, designated as CAND, which stands for 'candidates', marks a type according to patterns of ones in the original image and delays its input as well. All other input patterns are marked with a '0'. A processing element 43, designated PATINT, examines patterns of internal pixels and marks a corresponding type. All other patterns of internal pixels are marked with type 4. The pixel is deleted only if both marked types coincide. The proposed implementation is shown in Fig. 7.

TC is a candidate type as defined above, TI is an internal points pattern type minus 1 (to match it to a 2-bit signal). LOGIC FUNCTION block 44 (of 5 bit variables) is defined as follows:

Output = Input & (TC = (TI + 1)

and may be implemented as a gate array or as a separate look-up table or may even be included in the look-up table of the PATINT processing element 43.

In the labeling procedure, a label of the current pixel is defined by a label of one of three of its neighbors: either from left, or from the top or from top-right. There are two additional possibilities for a label value at the current pixel: It may be 0 for all pixels with 0 and for isolated pixels with value 1, or it may be a 'new' value for a 'start' event, when a new yet unused label value has to be assigned. The label, assigned to a given pixel, does not depend on the bottom row and the right pixel (as they have not yet been visited by the labeling).

A component labeling, either the main labeling or the auxiliary labeling may be performed by processing elements, which work in parallel on the input signal representing a type of 3×3 neighborhood of the bit map to be labeled. A standard processing element may be used for a recursive labeling of two label bits, using its two internal pipelines. In the proposed implementation, each labeling pipeline is controlled through a corresponding look-up table by 3 bits, representing a labeling type and a bit of a 'new' label.

The labeling type is detected by a single PE - the labeling classifier, common to all labeling PE's. The labeling classifier marks events 'top', 'left', 'top-right', 'start' etc., corresponding to various ways of a label assignment. When the type is 0 (e.g. for 0 input in the central pixel), then the look-up table output is set to the background value 0. The events 'top', 'left', 'top-right' cause the output from the look-up table to be equal the corresponding labels of already labeled neighbors: T, L or TR. The start event causes the output from the LUT to be equal to a new 'label' bit. Possible values of new labels either reside in the first-in/first-out buffer if a mechanism is provided for reuse of labels, or are output values of a label generator, for example, new labels may be equal to a pixel coordinate.

In order to save memory space, an optional mechanism for label reuse may be incorporated into the labeling hardware (separate for the auxiliary labeling).

A block diagram of the label reusing hardware mechanism is shown in Fig. 8. Random-access memories 45 and 46 work in a ping-pong manner, i.e. they interchange each other for each new row. As shown in Fig.8, RAM3 45 is being updated for the current row, denoted as 'c', RAM2 46 and RAM1 47contain information relating to two previous rows. RAM3 45 uses the current label as an address address, and a '1' is written at this address if a write enable (WE) signal is present, which is equivalent to a 'lu' ('label used') signal. At the end of the current line, RAM3 45 is filled with '1' in addresses of labels which were encountered on the current row (provided RAM3 456 was initially set to 0).

At the beginning of the current row, RAM2 46 and RAM1 47 contain a '1' at addresses of labels which were used correspondingly on rows c-1 and c-2. For each value of an 8-bit part of an X coordinate there are the 'read' cycle and the 'write' cycle. In the read cycle, both values in RAM2 46 and RAM1 47 are read, and the occurrence of a pattern 0 (in RAM2) and 1 (in RAM1) shows that the corresponding label value may be reused. It is fed to the input of the unused label FIFO 48, and the second level processing may be optionally informed about releasing the label value. In the write cycle the content of RAM2 46 is written into RAM1 47, and 0 is written into RAM2 46, preparing both memories for the next row.

The FIFO (first-in/first-out) buffer 48 may be implemented as a random access memory with two pointers for read and write addresses. Prior to an inspection run, the FIFO 48 has to be initialized by filling it with all possible labels (without repetition).

The upper bound for the maximum number of labels in use is $1 + l/2$, where $l$ is the row length. It is suggested to use a special line smoothing processing element which, -with possible additional trimming,-successfully eliminates extraneous label starts, providing a possibility to use only 8-bit label for $l = 2048$.

A (horizontal) line smoothing recursive element reduces line edge noise so that a line skeleton has much simpler structure. This PE is obtained by connecting another PE output, say O2, with a control signal input, say C1, and setting $O1 = C$. The LUT definition for the line smoothing PE with O3 as its output is as follows

$O3 = O2 = 1$ for the following templates:

v 0 0   v 0 x   1 1 1   1 1 1  (x is "don't care")
u 0 x   u 0 1    u 0 x   u 0 1  (u is 1 for C1 = 0, is x for C1 = 1)
1 1 1   1 1 1   v 0 0   v 0 x   (v is x for C1 = 0, is 0 for C1 = 1)

$O2 = 0, O3 = C$ for all other templates.

At least one signal processor is attached to each logical channel of the GCAS 3 for comparing graph representations of data and the reference, and establishing their equivalence or their miscorrespondence. In principle, there may be two-way communication between the first-level hardware of the GCAS 3 and the attached second-level signal processor. For example, the second level may send inquiries for a current value of the label at prescribed coordinates, or may send a list of coordinates of reference vertices to be compared on the first level with data special points.

To provide the full information on a data SR-graph in each special point, its coordinate, type, main and auxiliary labels are sent to the second level. For merge points, a label pair is sent. Besides this message, a label release may be sent as well.

Since a 'start' event requires a 'new' label from FIFO buffer 48, and initiates the label transfer to the second level, the second-level processor may be principally informed what labels are active, i.e. what labels are used to actually label some conductive areas. The coordinate may be sent either as a pair Y, X (Y is the row index, X is a pixel index in the row), or as an X only, provided that a special message is sent at the row end to notify the second level.

The transformation which describes small board distortions around the current scanning line is

$$U = X + A0 + A1 \bullet X + A3 \bullet X^2$$

$$V = Y + B0 + B1 \bullet X + B2 \bullet Y + B3 \bullet X^2 + B5 \bullet X \bullet Y$$

where (X,Y) and (U,V) are points in the inspected and reference boards, respectively. The A's and B's are the transformation parameters. Their contribution to X, Y is comparatively small. These coefficients are supposed to depend on the Y-coordinate ( = Y0) of the current scanning line.

For registration, only those special points X(i), Y(i) of an inspected board have to be matched to the corresponding special points U(i), V(i) of the reference which lie in a continuously progressing strip above a current row with a width of about one tenth of the row length.

Parameters of the transformation may be computed based on already matched pairs of points in the above-mentioned progressing strip, by either the least square method, -which, however has problems of efficiency and stability-, or by one of the gradient methods which are simpler and more stable but less accurate.

Since geometrical distortions may be assumed to change slowly with increasing Y0, the transformation may be supposed to be the same one over several subsequent rows until the next special point is encountered. However, when the next point is rather far in Y-direction from previous points, the identity transformation serves as the best fit. To provide a slow transfer to the identity transformation or, alternatively, to provide varying weights for special point pairs, decreasing away from a current scanning line, a slow 'forgetting' of computed coefficients is proposed, whereby with each new row each coefficient is multiplied with its constant, which is less than 1.

Each new special data point is matched to the reference point by its U, V coordinates, recomputed by the transformation formulae, and in accordance with the reference point tolerances, which may change with the type of the point, or even may be defined separately for each point (in a reference connectivity list). After a matching, a new pair serves for updating the transformation coefficients.

The invers transformation, approximated by a transformation of the same type as the direct one, provides a possibility for computing the X-coordinates of the left and right edges of the current reference line as it maps into an inspected board. As the transformation gives a fair extrapolation of distortions on several subsequent lines, it may be expected that the next scanning line will roughly map onto the same interval.

A special feedback channel transfers the two computed offsets for the beginning and the end of the scanning line from the second level down to the mask gate 24. For certain purposes, the refer-

**0 247 308**

ence may also contain information on changes in the start and end pixels for the current line. This may be incorporated, for example, in order to avoid intersection of a wide feature by a boundary of a strip to be tested.

The data structure for the graph equivalence check in the second level consists of the following:

-A list of special points, including knots. Entries in this list are ordered lexicographically, i.e. in the order in which they will appear in scanning. This list describes vertices of the data SR-graph, its type (including degree and an activity number) and position.

-A list of reference vertices (special points), ordered lexicographically. Each entry contains a vertex degree, a vertex activity number, and flags for a success of matching between the reference and the data vertices.

-A reference edge follower. This is an array with an entry for each edge (i.e. an edge which has not yet arrived at its second vertex). For each entry, the following items are defined: A global label which is an index for the first edge vertex in the list of reference vertices, two flags for edge termination and for the success of matching between the reference and the data edges.

-A union and find mechanism which consists of a tree structure for each active data entity. Each tree in this structure describes a union between those active data edges which are connected only through pseudovertices, as were received from the first level.

-A data entity follower. This is an array with an entry for each active data entity (i.e. an active entity which has just started but not yet finished). Each entry in the data entity follower contains a global label, a number of true vertices and an activity number of a corresponding entity (i.e a predicted number of terminal points of the entity, which were not encountered yet). An activity number is easily updated each time a pseudo-vertex is encountered. If an activity number becomes zero, i.e. an entity was finished, it should be removed from the array and from the union and find structure. A global label equal either to a global label of a corresponding reference edge, if such a correspondence is established, or to a special sign (call 'null'), if an entity starts from a point for which there is no corresponding reference vertex.

The algorithm is operated by data coming from the first level; it tries to match each current data special point to the reference. There are two cases to be distinguished:

1. The current data special point is a T-vertex, i.e. there is a corresponding reference vertex. In this case the necessary update of the reference edge follower and the data entity follower arrays is performed.

or equal to the reference vertex degree. In the other case, an 'open' is flagged with the coordinates of the vertex.

a check is performed whether the corresponding edge exists in the reference, flagging a success in the reference edge follower array. In the other case, a 'short' is flagged with the coordinates of the vertex.

2. The current data special point is a P-vertex, i.e. it does not correspond to any reference vertex.

entity follower array is updated. The updating is made either by adding a 'null' entry if the entity just starts, or by updating the entity activity number.

exist any more. In this case a check is performed whether this edge has a 'null' entry, i.e. it does not correspond to any valid reference edge. If 'yes', then it is removed from the data entity follower array and from the 'union and find' tree structure.

reference edge, the activity number of the corresponding data vertex is updated. If the updated value is less than the reference vertex activity number, then an 'open' is flagged with the coordinates of the P-vertex. A fault is flagged as well for any reference vertex that remains unmatched.

An optional arithmetic channel performs several simple arithmetic operations on an incoming bit map. An input to the arithmetic channel is GA, the binary data flow from the data distributor of the combined system, and GC, the control signal, which enables/ disables processing in certain regions. The output of the arith metic channel is a 7-bit data stream, when the first five bits of each 7-bit data item represent some arithmetic value over one of adjacent $6\times6$ pixel windows of the bit map on the input, the remaining two bits represent an additional information, referred as a weight. The output data flow has a rate 36-times slower than the rate of data acquisition. This flow is transferred to an attached signal processor which accomplishes an estimation of a chosen arithmetic feature and its comparison with a nominal value.

The are two possible uses of the arithmetic channel:

-Estimation of average line width (labeled WIDTH) in order to flag as an error such conductors, which have a width deviating from a nominal value along too long a distance, but which still satisfy the criteria for local minimal width.

-Estimation of average conductor density (labeled DENSY) for testing a large conductive area with a set of periodic voids which are not described in the reference file sine they are caused by some technology reasons. A common requirement in this case, viz. that a conductor should cover, in the average, a certain share of each sufficiently large subregion, cannot be tested by the reference comparison.

The arithmetic channel may be easily reprogrammed for maximum/minimum or other arithmetic operations over a 6×6 block instead of averaging.

The arithmetic channel consists of the following blocks, which are connected sequentially (see Fig. 9): A preprocessor 49 which produces a 5-bit data stream with some values for each pixel, a preaverager and decimator 50 which contains the following blocks, connected in sequence: A ROW-3:1 arithmetic block 51 which averages three adjacent horizontal pixels, followed by a 3:1 decimator, a COLUMN-3:1 arithmetic block 52 which averages three adjacent vertical pixels from the preceding block 51, followed by a 3:1 row decimator; a ROW-2:1 arithmetic block 53 which averages two horizontally adjacent 3×3 blocks and decimates data by 2:1; a COLUMN-2:1 arithmetic block 54 which averages two vertically adjacent blocks of 3×6 pixels and discards every second row, the output values being averaged over 6×6 pixel blocks, and a first-in/first-out data smoother 55 to provide an almost even and 36 times slower data rate at the input to a signal processor; and a second-level signal processor 56 for final computations, comparisons and decision making.

A preferred implementation of the arithmetic channel is based on processing elements and ROMs for performing all logical and arithmetic operations and reprogramming.

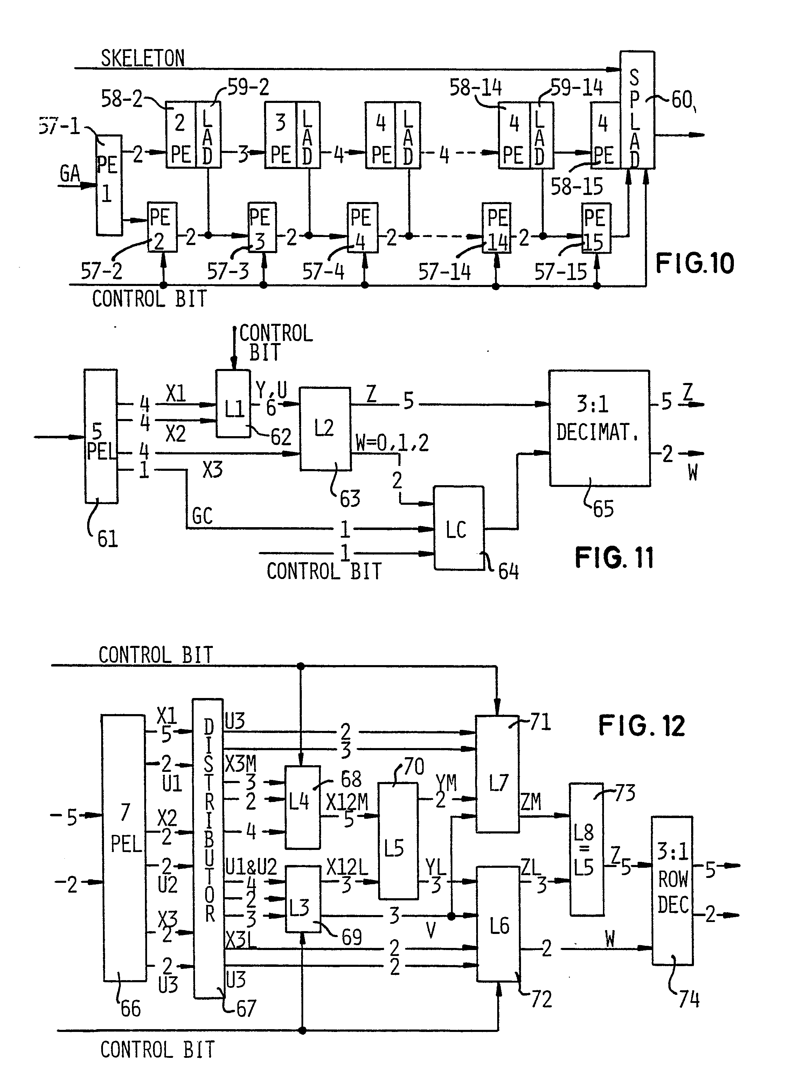

A block diagram of preprocessor 49 of Fig. 9 is shown in Fig. 10. In the preferred implementation, it comprises 15 stages, the first stage comprising a processing element 57-1, identical stages 2 through 14 comprising a cascaded circuit consisting of a processing element 57-2 through 57-14 and a combination of a processing element 58-2 through 58-14 with a look-up table adder 59-2 through 59-14. The fifteenth stage comprises a processing element 57-15 and a combination of a processing element 58-15 with a special look-up table adder 60.

The look-up table adders 59-2 through 59-14 map a 5-bit input signal into a saturated 4-bit sum of the first four bits with a last fifth bit. The processing elements 57-2 through 57-14 serve to appropriately delay these four bits and to convey them to the next stage. The look-up table adders may actually be implemented as a part of the look-up table of the corresponding processing element. In the preferred implementation of Fig. 10, processing elements 57, except for the first and the last one, have a two-bit output, viz. for the bit which is routed to the adder 59, and for the bit which is routed to the processing element of the next stage.

The two bits mentioned before have different tasks to perform depending on the program being executed. In the program called 'WIDTH', the preprocessor 49 performs a so-called 'distance transform', i.e. it computes, for each conductive pixel, its minimum distance to a boundary of the entity, to which the pixel belongs. The values of the distance transform are taken only on a skeleton which is fed to the special look-up table adder 60.

In the program called 'DENSY', the preprocessor 49 is used to compute a number of conductive neighbors. The definitions below relate to both output bits, referred in a corresponding order with a slash between them:

WIDTH: PE1 = (C + NAR8)/NAR8,

PE3 = PE5 = PE7 = PE9 = PE11 = PE13 = NAR8/NAR8, PE15 = NAR8,

PE2 = PE4 = PE6 = PE8 = PE10 = PE12 = PE14 = NAR4/NAR4

<SP LAD> = <LAD> * <skeleton signal>.

DENSY: PE1 = (TL + C)/C,

PE2 = T/C, PE3 = TR/C, PE4 = L/C, PE5 = R/C, PE6 = BL/C,

PE7 = B/C, PE8 = BR/C, PE9 = 0, PE10 - PE15 - any

<SP LAD> = <LAD>; (skeleton is disregarded).

Herein, 'PE1' through 'PE15' stands for processing element 57-1 through 57-15, 'LAD' for all identical look-up table adders 59-2 through 59-14, and 'SP LAD' for the special look-up table adder 60.

The average over a $6 \times 6$ pixel window is defined for the DENSY program as the <sum of all 36 pixels>/36, but for the WIDTH program it is defined as the <sum of all width entries>/<the number of non-zero entries>. The difference in these definitions demands various pre-averaging functions, switched by control bits.

A possible implementation of the ROW-3:1 arithmetic block 51 is shown in Fig. 11. Five processing elements are combined in block 61; they provide output signals which constitute three 4-bit numbers X1, X2, and X3 and which correspond to three adjacent pixels, viz. L, C, and R (except for the signal GC). These output signals of block 61 are respectively supplied to look-up tables (LUT) 62, 63, and 64, which may be implemented as ROMs. The first LUT 61 combines two values: X1 and X2. For the purpose of the WIDTH program, its output contains an information on a number of non-zero entries (weight), which may be equal in this case only to 0, 1, and 2. The second LUT 62 combines the output Y from block 61 with X3, taking into account weight U. For the DENSY program, the weight is modified in LUT 61 and in LUT 64. The final result, issued from 3:1 decimator 65, will be an average Z, compressed to five bits, and a weight W, comprising two bits the weight for the DENSY program being equal to the signal GC.

The COLUMN-3:1 arithmetic block 52 is described in Fig. 12. Seven processing elements are combined in block 66. Their look-up table functions are chosen to provide 7-bit information for the pixels in each row, viz. values X1: = T, X2: = C, and X3: = B, and weights U1, U2, and U3. The distribution box 67 is not actually existent, it merely serves to make the figure more readily understandable in showing the distribution of the bit wires. The suffixes M and L respectively indicate the most and least significant bits of a corresponding variable. 'Variable X12' stands for the intermediate result of combining X1 and X2. ZM and ZL are intermediate results the sum of which is Z.

Since a 14-bit LUT for a straightforward combination two 7-bit data items (number and weight) is not available, both numbers are split on the least and the most significant parts. For example, two 5 bit values X and Y may be represented as follows:

$$X = XM + XL, \text{ and } Y = YM + YL,$$

where XM, YM are respectively the three and two uppermost significant bits of X, Y, augmented by two and three zeros, respectively. Furthermore, XL, YL are the two and three least significant bits of X and Y respectively.

As operations are linear, they may be performed on a pair XM and YM, which requires a 9-bit input (3 + 2 + 4 bits for weight), and then on a pair XL and YL, which also requires 9-bit input. The results of these partial operations, which may be five bits and three bits respectively, are to be added in a LUT adder. This process is consistently employed in all other LUT blocks 68 through 73. The final output signals are supplied by 3:1 decimator 74.

The preferred implementation of arithmetic blocks 53 and 54 does not differ considerably from the implementation proposed for the other blocks and, therefore, is not shown here.

The final results may be computed and compared with a nominal value on the dedicate signal processor, although it is, in principle, possible to implement the computations in special purpose hardware as well. The data from the special purpose hardware of the arithmetic channel is treated as an image of smaller size, comprised of 'big pixels' each representing a $6 \times 6$ pixel block of the original image. The new line size is six times smaller than a row length.

The processing is a recursive filtering of incoming data, except for a conductive line start, or a boundary of a region, in which an average density has to be computed. In these exceptional cases, a filtered data initialization is performed in such a way that occasional local data changes will not cause a defect detection. The processing is performed in the manner of data scanning, i.e. each incoming big pixel is processed, assuming that the information on previously processed big pixels is. available. Computed average values are compared with tolerances, flagging a defect, if they are outside of the tolerance range.

In certain cases there are more than two different tolerances on minimal line widths on the same layer. A rather straightforward modification deals with these cases without unnecessarily increasing the number of the logical channels. The hardware structure is based on joining the arithmetic and logic channels.

Different tolerances on the minimal trace width are designated as follows:

$$0 < H1 < H2 < ... < Hn,$$

where Hn is greater than a supernarrowing depth, and n is a small number. Using a result BR of broadening in a logical channel and a result H of the distance transformation of the original image OI in the arithmetic channel, weights W may be assigned to each pixel as follows:

if $H(i-1) < H = < Hi$, then $W = i$ (for $i = 2,...,n$)

if $H < H1$, then $W = BR(= 0, 1)$

defining a 'weight' image, which is only three bits deep for $n = 7$.

Skeletonizing the broadened and the original image BR and sampling a 'weight' image only on the union of the two skeletons, one receives a 'weighted' skeleton.

In order to avoid complications with small voids, a 'weighted' skeleton may be obtained as well by skeletonizing the original image representation and then by skeletonizing the broadened image in such a way that the skeletonizer is switched to a unity operation on the skeleton of the original image, which is fed for that purpose to control wires of the second skeletonizer. The final image is forced to the skeleton of the original image in all points except for extraneous connections due to small gaps, and except for small voids which remain filled with 1's, constituting blobs. to clear out voids, all what remains to do is to remove all internal points, leaving only boundary ones. This is done trivially by an additional processing element. The weight is smapled on the final skeleton, producing a 'weighted' skeleton.

Each point, where a weight along the skeleton changes is detected and considered as a special point, that is an SR-graph vertex. Each edge of the SR-graph is characterized by a weight which should be read from the 'weighted' skeleton only at rope terminations, and should then be sent to the second-level microprocessor. This processor receives a full description of an SR-graph, including its edge weights. A fault-free pattern has to have an equivalent to the reference RR-graph, while an equivalence assumes a certain relation between data and reference weights, e.g. an existence of an RR-graph edge either with at least the weight of the reference edge, or with exactly the same weight, depending on whether or not a too wide connective line is considered as a fault.

In order to check an equivalence in one of the senses mentioned above, the second-level processor maintains a tree structure of the union and find mechanism separately for each possible value i of an RR-edge weight, where for a fixed i ropes with a weight greater than i either are also accounted, or are considered as not connective.

If the reference graph has an edge with a weight i, the second-level processor has to establish the existence of a regular component with a weight of either at least i, or exactly i. Shorts and irregular components are detected, using a weight 1, that is from a broadened image. It also becomes possible to define a weight of an edge which causes a shortage, and thus to report a short severity.

The above two definitions of a relation between the reference weight and an RR-edge weight are tailored to a specific requirement, viz. that if a void is present inside a conductive line, then the conductor width has to greater than predetermined minimum width, at least from one side of the void. This requirement may be sometimes reduced to the requirement that the sum of conductor widths from both sides of the void has to be greater than the minimum width. In such a case, the only change which has to be made is the redefining of the relation between the reference and data edge widths in a microprocessor program. An RR-edge in this case has to include a computation of the maximum 'flow' through a regular component, which is a simple function of weights on its ropes.

As has become clear from the preceding description, the invention, being implemented either in accordance with the preferred embodiments described or by other means but within the scope of this invention, has a number of significant advantages. The inventive method, as opposed to prior art methods, is based on a fatal fault definition, which directly relates to the main function of the printed circuit under investigation, viz. either to conduct or to isolate properly between certain points. As such, the method checks conductivity attributes of the acquired optical data and compares them with the reference list. The proposed method detects all conductivity violations in conductive traces and voids/extraneous conductors in 'wide' areas, in accordance with the above-mentioned fault definition. Inessential distortions of ideal conductive traces, such as small voids, shifts, nicks, etc., are not flagged as fatal faults, although they are all detected and their number may serve as an additional indication for quality control. Thus, the proposed method detects all fatal faults and only them, being free of escapes and over-kills.

As this invention employs the high-level reference description, the reference volume is expected to be much smaller than in any reference comparison method. This extends the range of the proposed method towards much finer printed circuit technology, where the reference comparison method has to operate with impractically huge reference volumes.

As manual control and classification are no longer needed, full automation becomes possible with human labor spent only on possible fault repair.

The method according to this invention provides on-the-fly processing of incoming raster scan data and on-the-fly fault documentation. However, in contrast to other methods, only fatal faults are documented.

The preferred particular embodiment of this invention provides an easy reprogramming of a special purpose hardware and an attached processor for any predetermined kind of preprocessing and its parameters, covering an inspection of practically all printed circuit patterns. The preferred embodiment also provides for automatic computation of the reference conductivity file.

The method provides in addition a check of average line width or average conductor density, covering an inspection of such printed circuit patterns which can not be inspected by other methods.

### Claims

1. Optical inspection method for the automated detection of fatal faults in printed circuits wherein the said printed circuits are scanned by an optical scanner, and the scanner supplies a binary representation of the features at the surface of the printed circuit being inspected, characterized in that the said binary representation, or a pre-processed version thereof, is subjected to a local component labeling process in data scanning order, that during said component labeling an information is gathered on-the-fly at a rate corresponding to the data acquisition rate, and which information establishes whether an arbitrary pair of points on the printed circuit under inspection belongs to the same conductive entity, and wherein, at the same time, global labels which are computed in certain pre-chosen check points are analyzed for the existence of conductive connections between them, the detected connections being compared with the precomputed correct connections between corresponding check points stored in a reference list, with any miscorrespondence indicating a fatal fault.

2. Method in accordance with claim 1, characterized in that the comparison is carried out by establishing a correspondence between global labels in check points of a certain type and precomputed reference global labels in corresponding points, and that the global labels of other check points are compared with corresponding ones of the reference, and that any miscorrespondence indicates a defect of the 'open circuit' type, while any merge event between different global labels indicates a defect of the 'short circuit' type.

3. Method in accordance with claim 1, characterized in that the component labeling is performed by assigning, to each current picture element, a label bit equal either to a corresponding label bit of one of the immediate neighbors of this picture element, or equal to zero, or to a corresponding bit of a new, still unused label, the decision depending on the type of the 3×3 neighborhood of the current picture element, this type being defined by a single processing element which maps the neighborhood of the current picture element into a new bit number, the latter being used to control those processing elements that perform the labeling, and to control the channel connecting the labeling processing element with a microprocessor which compares the resulting connectivity information with the reference list.

4. Method in accordance with claim 1, characterized in that in parallel with said local component labeling process a random access memory (RAM1) is filled with flags at addresses equal to labels, said flags indicating active labels used in the current data row, that the contents of two further random access memories ries (RAM2, RAM3) are sequentially analyzed for the occurrence of a label which was active two rows ago, and which became inactive one row ago, the value of such a released label being loaded into a first-in/first-out buffer the output signal of which serves as a new label for component labeling, said value of a released label being optionally transferred to a microprocessor for keeping track of the active labels.

5. Method in accordance with claim 4, characterized in that said random access memory (RAM1) is filled with flags only at such label addresses which correspond to start events, when the label has just been taken from said first-in/first-out buffer, as well as for those types of 3×3 neighborhoods of a current picture element for which the label is equal to the label of an immediate neighbor in the preceding row.

6. Method in accordance with claim 1, characterized in that either the image of a scanned printed circuit, or its preprocessed version is skeletonized by thinning, conserving a 4-connectivity such that there do not exist skeleton points with more than four external connections, said special points being 0-, 1-, 3-, and 4-joints, and those 2-joints in which a start-new-label event or a merge-two-label event occurs, and being described in terms of their 3×3 neighborhood which is mapped into a few-bit output signal representing type and control signals for the generation of a message to be transferred to a microprocessor.

7. Method in accordance with claim 6, characterized in that a stage for one pixel 4-connectivity thinning consists of three processing elements, two of which are fed in parallel by the output of the third one, that the latter labels internal pixels of a conductive entity image representation, and that the two other processing elements classify each pixel in accordance with a pattern of its 3×3 vicinity and a pattern of internal points in its 3×3 vicinity, a pixel being deleted if both classifications coincide.

8. Method in accordance with claim 6, characterized in that prior to a skeletonizing and a component labeling operation, an image representation of a scanned printed circuit undergoes a modification by a horizontal edge smoothing processing element which maps 10-bit input consisting of a 3×3 neighborhood of a current pixel and an additional bit to a two-bit output, one of the output bits being used as an additional input bit for the next pixel to be processed, and that a logical function of a processing element is defined in a way conserving the connectivity of the image.

9. Method in accordance with claim 6, characterized in that for enabling the connectivity analysis of multi-connected patterns, a skeletonized image is subjected to the deletion of certain special points, including 3-joints, and 4-joints, and non-skeleton points, that the information on deleted points, with the exception of their labels, is transferred to a microprocessor which tries to match these points to vertices of a pre-computed graph representation of the skeletonized reference, that at the same time local component labeling is performed on disconnected pieces of the skeletonized image, wherein the information on disconnected special points of the skeletonized image, namely on terminal points, 'start' events and 'merge' events, may include their local labels, that said microprocessor uses those of the special points for which there exists no match in the reference, as regular points, in particular for local label merging, keeping track of each skeletonized conductive entity, including information on the number of times this entity intersects a current row, that the reference is represented as a graph with a list of vertices and their connections by simple edges, such that the information in the microprocessor enables the comparison of this graph representation with a graph representation of a skeletonized printed circuit image, where any miscorrespondence indicates a defect, and a delay in a decision on a defect being less than a constant number of rows, enabling on-the-fly defect data documentation.

10. Method in accordance with claim 9, characterized by marking special points to be deleted from a skeleton together with their immediate skeleton neighbors, and also marking skeleton neighbors of already marked points, and repeating this marking operation several times, and by removing each time, except for the last time, marked points from the disconnected skeleton and producing, as a result, two separate binary representations of a skeletonized image, one containing disconnected skeleton pieces, the other containing vicinities of deleted points, viz. knots, while disconnected skeleton edges have common points with some knot in their terminal points, a knotted image being subjected to an auxiliary local component labeling, and further characterized in that additional information on mergers and starts of auxiliary labels is transferred to a microprocessor, while a disconnected skeleton is being subjected to the usual local component labeling and, in addition, auxiliary labels are being transferred to the microprocessor in terminal points of disconnected pieces.

11. Method in accordance with claim 10, characterized in that the marking for special points is done alternately for special 2-joints and 3-/4-joints in such a way that knots, originating from 2-joints and 3-/4-joints never merge together.

12. Method in accordance with claim 1, characterized in that images of scanned printed circuits are preprocessed considering predefined tolerances for minimum conductor width and for minimum acceptable interwire gap width, by narrowing/broadening conductive entities in such a way that the output image representation either is narrowed to about one half of the minimum acceptable conductor width, causing a disconnection in places of too narrow wires, or is broadened to about one half of the minimum acceptable gap width, causing a short circuit in places of too narrow gaps.

13. Method in accordance with claim 12, characterized in that at least two identical channels are fed in parallel with the binary image representation, both channels containing a preprocessor with a number of processing elements sufficient to cover the maximum number of narrowing/broadening operations, the processing elements receiving two additional input bits enabling the choice of one of at least three programs, viz. for narrowing, for broadening, and for a unity operation which leaves the input unchanged, the distribution of these control signals enabling the narrowing/broadening operations in accordance with said predetermined tolerances, and the analysis of the narrowed/broadened images simultaneously through a comparison of their connectivity attributes with pre-computed connectivity attributes of correspondingly narrowed/broadened references.

14. Method in accordance with claim 13, characterized in that three identical channels are in parallel fed with the binary image representation, two channels being programmed for different numbers of narrowing, including identity, the third channel being programmed for broadening, each channel comparing the connectivity attributes against correspondingly prepared reference connectivity attributes.

15. Method in accordance with claim 13, characterized in that the binary image representation is split by a transformation block into two possibly complementary images, one of which containing only connectivity type patterns, and the other one containing only large area patterns, that the first binary image representation is fed into a connectivity testing block for testing by comparison of its connectivity attributes with corresponding connectivity attributes of the reference, and that the second binary image representation fed into a reference comparison scheme which either works idle for an inspected printed circuit with only narrow line patterns, or which provides on-the-fly data alignment and comparison with the pre-computed reference of only large areas, and which produces an indication of care/don't care regions on those large areas.

16. Method in accordance with claim 15, characterized in that said transformation block performs a narrowing operation on a number of picture elements larger than corresponds to the maximum acceptable line width, and that the resulting supernarrowed binary image representation is subtracted from an appropriately delayed original image representation, the ensuing difference containing only connectivity pattern to be tested, while the supernarrowed image representation contains only large areas to be checked by the reference comparison - scheme.

17. Method in accordance with claim 15, characterized in that for enabling a testing of either an average line width or an average conductor density, an additional arithmetic channel is fed in parallel with said logical connectivity checking channels with either of said two image representations, that this arithmetic channel comprises a preprocessor, a preaverager and a decimator, the output of which is hooked to an attached microprocessor, that said preprocessor converts a binary image representation into a few-bit output data stream, wherein each data item is a result either of a distance transformation or of a neighbor number counting operation, and that said preaverager performs a weighted averages in each $N \times N$ pixel block and transfers the result to a microprocessor which accomplishes an averaging by recursive filtering of incoming data and compares the results with a given nominal value within given tolerances.

18. Method in accordance with claim 17, characterized in that for enabling a distance transformation, said preprocessor of the arithmetic channel comprises a few lines of cascade-connected processing elements, the first cascade line including processing elements with 1-bit input and 2-bit output, which are controlled for choosing either a sequence of different narrowing operations or a sequence of nearest neighbor values, other cascaded lines of processing elements serving to delay a few-bit intermediate result which equals a sum of a result kept in a previous stage and an output bit of a corresponding stage of said first cascade, the summation being performed by a look-up table adder, whereas a few-bit result of the last stage may be set to zero for all non-skeletal pixels.

19. Method in accordance with claim 1, characterized in that registration of detected data check points is performed by matching them to corresponding reference check points and by simultaneous computation of coefficients of a geometrical transformation between the reference and the inspected data in the vicinity of the current scanning line, a detected transformation being used as well for partial reordering of the reference check points and/or for recomputation of data check point coordinates.

20. Method in accordance with claim 19, characterized in that the inspection is performed at a number of overlapping strips each strip being compared by a conductivity analysis with a slightly narrower reference strip, while the computed geometrical transformation is used in addition for computing two points which correspond to the two edges of the reference strip, and that at least one subsequent data line is set to zero outside the interval between the said points, thus providing processing of only the data described by the current strip of the reference.

21. Method in accordance with claim 17, characterized in that conductivity testing includes the computation of a geometric transformation between a scanned printed circuit and its reference and the use of transformation coefficients in the computation of dynamic offsets for the reference or optical data in a reference comparison subsystem, said dynamic offsets being used for the dynamic alignment of at least one subsequent reference or optical data row in the reference comparison subsystem.

22. Method in accordance with claim 9, characterized in that an input image representation is broadened and processed in parallel by a distance transformer to create an image of different weights, each weight corresponding to an actual line width and given tolerances, including the smallest weight for those picture elements which are not conductive and which belong to the broadened input image, that said image of weights is set to zero outside the skeletons of the broadened as well as the original input, that the received weighted skeleton is processed by a special point detector which includes the detection of points where the weight changes, and wherein the information on special points includes weight values in terminal points of skeleton segments, said information being transferred to the second-level microprocessor which treats this information as a graph representation of a skeletonized image with certain weights on each edge, and which compares this information with the reference graph representation that includes nominal weights on each edge of the reference graph, and that a predetermined relation between the reference and said weight values is tested, whereby an 'open circuit' error is indicated when a data edge has a smaller weight than the corresponding reference edge relating to a too narrow line, and optionally a 'too wide line' error is indicated when a data edge has a greater weight than the corresponding reference edge, a 'hard open circuit' is indicated when the data edge does not exist, a 'short circuit' error is indicated when there are extraneous connections of the smallest weight, relating to a too narrow gap, and a 'hard short circuit' is indicated when there are extraneous connections of any weight other than the smallest.

23. Apparatus for the automated optical inspection of printed circuits having an optical front end and processing facilities, characterized in that said optical front end (1) comprises an optical scanner (6) designed for linewise scanning of the printed circuit under investigation and for supplying, at its output line (7), a data stream arranged in the order of scanning, said output line (7) being connected to one input of a first look-up table (8) the second input of which is connected to a reference source (11, 12, 15), of an at least two-bit signal, and the output of which is hooked up to a transformation unit (9) which in turn is connected to a second look-up table (10) which interfaces with a general conductivity analysis subsystem (3) comprising special purpose hardware (16), signal processors (16, 17) and a local host computer (14), and with a comparator (13).

24. Apparatus in accordance with claim 23, characterized in that said special purpose hardware (16) comprises parallel and cascade interconnection of elementary recursive processing elements with possible logical functions between them, that each processing element maps a $3 \times 3$ neighborhood of a current pixel to a few-bit output, wherein several pixels of said $3 \times 3$ neighborhood may be fed by previously computed values of one of the output bits.

FIG.1

FIG. 2

FIG. 3

FIG. 4

FIG. 5

FIG. 6

FIG.7

FIG.8

FIG.9

FIG.10

FIG. 11

FIG. 12

9-86-006